# EUROPEAN PATENT APPLICATION

(11) **EP 4 564 110 A1**
(43) Date of publication of application: **04.06.2025**
(21) Application number: 23212986.6
(22) Date of filing: 29.11.2023
(51) Int. Cl.: G05B 17/00, G06F 30/20, G06N 3/0475

(54) **DEVICE AND METHOD FOR CONFIGURING A TECHNICAL SYSTEM**

(71) Applicant: Robert Bosch GmbH, 70442 Stuttgart (DE)
(72) Inventor: Hua, Nian, 71106 Magstadt (DE); Grossberger, Lukas, 64295 Darmstadt (DE); Metzen, Jan Hendrik, 71034 Boeblingen (DE); Zhang, Dan, 71229 Leonberg (DE)

(57) **Abstract**

According to various embodiments, a method for configuring a technical system is described comprising providing a large language model with connections to a simulation tool for simulation of the technical system depending on configuration parameters of the technical system and an optimization tool for deriving updated configuration parameters from current values of configuration parameters and a quality value of the current configuration parameters, inputting one or more prompts and configuring the technical system in accordance with values of the configuration parameters determined by the large language model in response to the one or more prompts.

## Description

The present disclosure relates to devices and methods for configuring a technical system.

Technical systems like machines, robots and vehicles (like for example an anti-lock braking system of a car) but also machines and systems involved in production processes and machining processes (e.g. drilling, milling, heat treatment, etc.) need to be configured in a suitable manner, i.e. configuration parameters like voltages, braking force, speeds or process parameters such as process temperature, process time, vacuum or gas atmosphere, etc., need to set in such a way that a desired behaviour or desired results (e.g. product properties) are achieved. Suitable values of configuration parameters may be determined using expert knowledge, simulation, experiments etc. However, this requires a high effort of human users. Therefore, approaches are desirable that make configuration processes for technical systems more efficient.

According to various embodiments, a method for configuring a technical system is provided comprising providing a large language model with connections to a simulation tool for simulation of the technical system depending on configuration parameters of the technical system and an optimization tool for deriving updated configuration parameters from current values of configuration parameters and a quality value of the current configuration parameters, inputting one or more prompts into the large language model comprising
- information about an application programming interface of the simulation tool;
- information about an application programming interface of the optimization tool;
- information about a mapping of simulation result data provided by the simulation tool to the quality value; and
- an instruction to determine the configuration parameters to optimize the quality value;
and configuring the technical system in accordance with values of the configuration parameters determined by the large language model in response to the one or more prompts.

The method described above provides a way for configuring a technical system which relieves a user from a high amount of manual work. The information about an application programming interface may be an (explicit) description of the application programming interface (e.g. the syntax used etc.) which the user may for example take from a manual of a corresponding tool. Alternatively, the user may provide (i.e. the one or more prompts may contain) information on how to find such a manual (e.g. a link).

Providing a connection to a tool (or also data base, other machine learning model, controller etc.) may for example mean or include providing a connection between a data processing device running the large language model with another data processing device running the respective tool (or data base). In case that the respective tool (or data base etc.) is running on the same data processing device as the large language model, providing a connection may also mean providing an internal connection (i.e. interface).

In the following, various examples are given.

Example 1 is the method for configuring a technical system as described above.

Example 2 is the method of example 1, further comprising providing the large language model with a connection to a controller of the technical system, wherein the one or more prompts comprise information about an application programming interface of the controller and an instruction to configure the technical system in accordance with values of the configuration parameters determined by the large language model in response to the one or more prompts.

In other words, the configuring of the technical system may be done by the large language model via a corresponding application programming interface (API). Once prompted, the configuration can therefore then be performed automatically.

Example 3 is the method of example 1 or 2, further comprising providing the large language model with a connection to a mapping tool for mapping the simulation result data provided by the simulation tool to the quality value, wherein the information about the mapping is information about an application programming interface of the mapping tool.

The large language model may thus use a tool for mapping the simulation results to the quality value, i.e. to evaluate the current values of configuration parameters. This allows an accurate and automatic evaluation and relieves the user from specifying the mapping per prompt.

Example 4 is the method of any one of examples 1 to 3, wherein the one or more prompts comprise examples of inputs and outputs of the application programming interfaces.

By providing examples to the large language model on how (i.e. with which output) the APIs react to a certain input, the large language model can control and use the tools more effectively.

Example 5 is the method of any one of examples 1 to 4, further comprising providing the large language model with one or more connections to one or more databases containing information about the behaviour of the technical system, wherein the one or more prompts include information on how to access the one or more databases and instructions to acquire knowledge from the one or more data bases and take it into account for the determination of the configuration parameters.

The one or more data bases may for example be connected to a data processing device running the large language model by one or more communication networks and the information on how to access the one or more databases may for example include addresses (such as URLs (Uniform Resource Locators), IP addresses, access credentials etc.). The large language model may for example be provided with internet access to access the one or more data bases. Thus, the large language model may acquire domain and/or expert knowledge allowing a more efficient and/or more accurate determination of the configuration parameters.

Example 6 is the method of any one of examples 1 to 5, further comprising providing the large language model with a connection to a machine learning model trained to perform at least a part of the mapping of simulation result data provided by the simulation tool to the quality value and wherein the information about a mapping of simulation result data provided by the simulation tool includes information about an application programming interface of the machine learning model.

For example, the machine learning model may operate on image data provided by the simulation tool (e.g. perform classification, object detection, regression etc.).

Example 7 is the method of any one of examples 1 to 6, comprising training the large language model with training examples comprising examples for the one or more prompts and target values for the configuration parameters.

Example 8 is a data processing device, configured to perform a method of any one of examples 1 to 7.

Example 9 is a computer program comprising instructions which, when executed by a computer, makes the computer perform a method according to any one of examples 1 to 7.

Example 10 is a computer-readable medium comprising instructions which, when executed by a computer, makes the computer perform a method according to any one of examples 1 to 7.

In the drawings, similar reference characters generally refer to the same parts throughout the different views. The drawings are not necessarily to scale, emphasis instead generally being placed upon illustrating the principles of the invention. In the following description, various aspects are described with reference to the following drawings, in which:
- Figure 1: shows an arrangement including a technical system arranged to perform a technical process, e.g. a physical or chemical process.
- Figure 2: illustrates a hybrid generative AI model according to an embodiment.
- Figure 3: shows a flow diagram illustrating a method for configuring a technical system according to an embodiment.

The following detailed description refers to the accompanying drawings that show, by way of illustration, specific details and aspects of this disclosure in which the invention may be practiced. Other aspects may be utilized and structural, logical, and electrical changes may be made without departing from the scope of the invention. The various aspects of this disclosure are not necessarily mutually exclusive, as some aspects of this disclosure can be combined with one or more other aspects of this disclosure to form new aspects.

In the following, various examples will be described in more detail.

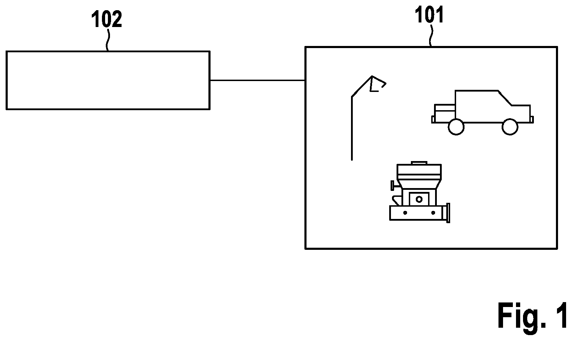

Figure 1 shows an arrangement 100 including a technical system 101 arranged to perform a technical process, e.g. a physical or chemical process.

The technical process can be any kind of technical process, such as a manufacturing process (e.g. a manufacturing of a product or intermediate product), a machining process (e.g. a machining of a workpiece), a control process (e.g. a moving of a robot arm or controlling a vehicle) or a measuring process. Such a technical process, i.e. the technical system 101, typically needs to be controlled, in particular configured (adjusted), e.g. a measuring apparatus needs to be calibrated, etc. For example, it may be necessary to adjust different manipulated variables of a device of the technical system 101 (e.g. as part of a calibration) in order to perform a physical or chemical process. For example, in a heat treatment using a furnace, the physical or chemical process may require calibration of the furnace temperature and/or vacuum. The corresponding configuration of the technical system 101 (i.e. the performance of the corresponding configuration task) is performed by a control device 102 which may for example operate according to human input.

Configuring a technical system can be a strenuous process. Arriving at a suitable configuration of a technical system may include a long process of ideation, prototyping, implementation, experimentation and result analysis. Each of these steps can require significant amount of domain knowledge, tooling / microservices, and specific hardware and software. Some steps can be quite lengthy and repetitive.

According to various embodiments, the configuration process is made more efficient by using generative AI (artificial intelligence), in particular a large language model (LLM) having access to one or more tools via one or more corresponding APIs (application programming interfaces). Thus, the configuration task may be performed using natural language as interface for a human user.

Generative AI systems are known for shortcomings such as hallucination and lack of grounding. However, domain knowledge and corresponding tooling (i.e. providing the generative AI model with external tools and corresponding API information, resulting in what is denoted as "hybrid generative Al model" in the following) can effectively mitigate this shortcoming such that a hybrid generative AI model can significantly improve the efficiency of configuration pipelines.

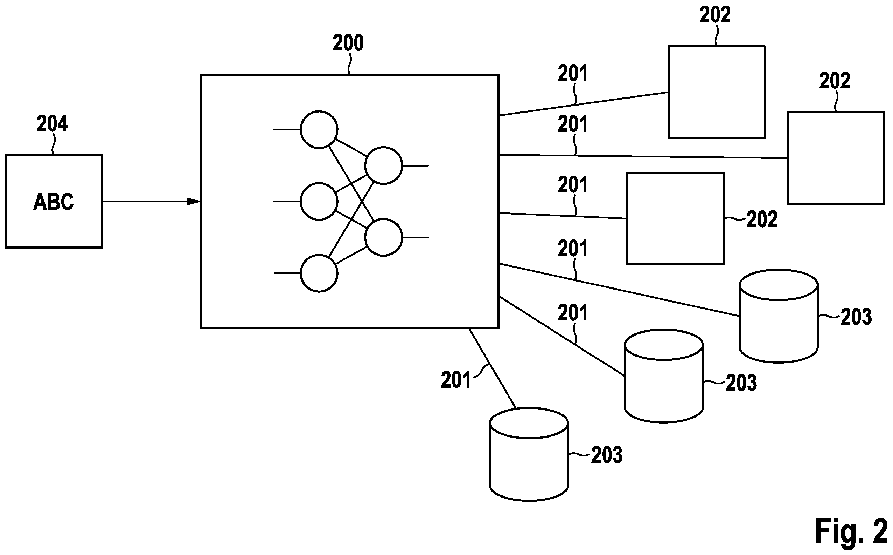

Figure 2 illustrates a hybrid generative AI model 200 according to an embodiment.

The hybrid generative AI model 200 may run on a data processing device, for example on the control device 102.

The hybrid generative AI model 200 includes a large language model (LLM). Accordingly, the hybrid generative AI model 200 has an interface for receiving natural language inputs (so-called prompts), in particular from a human user.

Further, the hybrid generative AI model 200 comprises connections 201 (which may be internal connections of a respective data processing device or connections to other data processing devices such as cloud devices) to tools 202 like simulators, digital twins, other AI services and to databases 203 e.g. including technical documents, knowledge graphs etc. By providing the hybrid generative AI model 200 with information about the respective APIs, i.e. information on how to access the tools 202 and databases 203 (and possibly control a tool, e.g. a simulation) which may be supplied to the hybrid generative AI model 200 in form of a text prompt 204 (in particular in form of natural language), the hybrid generative AI model 200 may acquire, by using the tools 202 and accessing the databases 203, domain knowledge about a configuration task, e.g. about a technical system 101 to be configured.

The hybrid generative AI model 200 may thus automate repetitive parts of a configuration task (which may also include generating code prototypes, e.g. for running a simulation).

The hybrid generative AI model 200 may for example
- Summarize and distil knowledge regarding a configuration task from publications and current domain know-how from one or more databases 203
- execute tasks with or without cross dependencies, including but not limited to:
   ∘ generate code e.g. for a simulation tool or optimization tool etc.
   ∘ execute API calls to the tools and databases e.g. to
      ▪ run simulations
      ▪ execute physical/lab experiments (by controlling e.g. robotic devices
      ▪ run other AI models.

The hybrid generative AI model 200 may perform planning and orchestration (of the tools 202 and the tasks to perform with them), including selection of tools 202 (and also databases 203) to acquire information.

For example, a user (e.g. researcher or engineer) may first ask the hybrid generative AI model 200 to come up with an orchestration plan, e.g. for example, ABS (Anti-lock Braking System) calibration. The user may then input a prompt like "Now that I have an orchestration plan from my Hybrid Generative AI Co-pilot to optimize my ABS calibration, can you execute these tasks and summarize the results for me?"

For example, the tasks that the hybrid generative AI model 200 identifies as part of planning and orchestration are
- Task 1: gather simulation data
- Task 2: gather test drive data
- Task 3: gather laws and standard data
- Task 4: gather domain know-how such as human feedback about the feeling of a certain controller setting for a specific manoeuvre and road condition
- Task 5: identify simulation tool to carry out simulation
- Task 6: identify optimization API for hyper parameter optimization
- Task 7: literature survey

Rather than using the general prompt above, the user may, e.g. after having been presented by the hybrid generative AI model 200 with the lists of tasks above, prompt the hybrid generative AI model 200 more specifically making reference to these tasks, e.g. as follows (in one prompt or a sequence of prompts):
Prompts for orchestration
   - "Run Task 5 with the help of Task 6, within the constraints of Task 3, referencing Task 1 and 4, while making sure that improvement can be observed when compared with Task 2."
   - "Run search and summary for Task 7"
Prompts for task execution
   - "Search and summarize the internet + internal cloud for the relevant publications and relevant internal know-how" (Task 7)
   - "Search sources identified for Tasks 3 and 4 and define parameter search space."
   - "Iterate the below steps until results are optimized:
      ∘ Trigger simulation runs (Task 5) while optimizing parameters as identified in Task 6 when necessary.
      ∘ Query results identified from Tasks 1 and 2 and compare against simulation runs."
Prompts for response generation
   - "Perform a literature survey and summarize (Task 7)'s response in a document"
   - "Based on simulation results, generate result summary, and proposal for next steps" (the result may be the optimized parameters and the next steps)

According to one embodiment, the hybrid generative AI model 200 has a connection to the technical system 101 or its controller 102. In that case, the hybrid generative AI model 200 may also be instructed (via a corresponding prompt) to configure the technical system 101 according to a configuration (i.e. values of optimized configuration parameters) it has determined.

The approach described above may be used same for configuration of various technical systems like for example an ESP (electronic stability program) system, chemical and physical (e.g. manufacturing processes) as described above, robot control and also innovation and experimental systems for improving technical systems and devices (such as for improving an ESP system), engineering design systems, or digital twins for a manufacturing processes where machine parameters or process chain interactions need to be evaluated.

As mentioned above, for using the tools 202, the hybrid generative AI model 200 may be provided by the user with an API description via a prompt. Simple Examples are given in the following.
- Tool: finite-element method based simulation of a physical system. API description:
   def simulate(initial_state, control_parameters): -> measurements
- Tool: objective function evaluation tool. Interface:
   def objective_function(measurements): -> objective_value
- Tool: black-box optimizer running e.g. Bayesian optimization. API description:
   def optimize(control_parameters, measurements): -> (next) control_parameters

As mentioned above, the API description may be supplemented with examples in the prompt to allow the LLM 200 to better use the respective tool 202.

It should further be noted that the objective function may also be manually specified (in the prompt 204) or also provided (i.e. determined) by the LLM 200 based on human instructions, e.g. a description in words of the objective function).

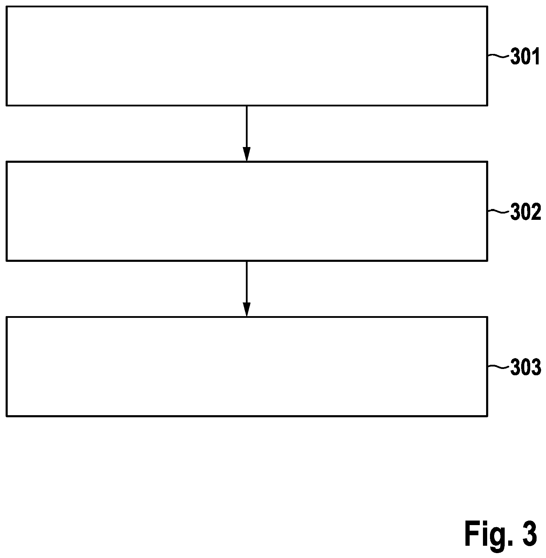

In summary, according to various embodiments, a method is provided as illustrated in figure 3.

Figure 3 shows a flow diagram 300 illustrating a method for configuring a technical system according to an embodiment.

In 301, a large language model is provided with connections to a simulation tool for simulation of the technical system depending on configuration parameters of the technical system and an optimization tool for deriving updated configuration parameters from current values of configuration parameters and a quality value of the current configuration parameters.

In 302, one or more prompts are input into the large language model comprising
- information about an application programming interface of the simulation tool;
- information about an application programming interface of the optimization tool;
- information about a mapping of simulation result data provided by the simulation tool to the quality value; and
- an instruction to determine the configuration parameters to optimize the quality value.

In 303, the technical system is configured in accordance with values of the configuration parameters determined by the large language model in response to the one or more prompts.

The approach of figure 3 can be used to determine configuration parameters for operating and/or controlling a technical system, like e.g. a computer-controlled machine, like a robot, a vehicle, a domestic appliance, a power tool, a manufacturing machine, a personal assistant or an access control system. The technical system may also for example be a virtual sensor which, based on a sensor signal obtains an information about elements encoded by the sensor signal (i.e., an indirect measurement may be performed based on the sensor signal used as direct measurement), a video/audio analysis system et al. (e.g. for classification) like a system for classifying sensor data, detecting the presence of objects in the sensor data or performing a semantic segmentation on the sensor data, e.g. regarding traffic signs, road surfaces, pedestrians and vehicles. The determination of configuration parameters may include determining of a continuous value or multiple continuous values. The technical systems may for example be a controller (e.g. for a vehicle, possible Al-based) to be configured to perform a regression analysis, e.g., regarding distance, velocity, acceleration, tracking an item, e.g., an object, in input data. The method may also be used to in a technical system.

The large language model may be trained using reinforcement learning and may analyze data (e.g. scalar time series), and then operate (in particular configure) the technical system accordingly.

The approach of figure 3 may be used for active learning/testing (test bench) and data curation , e.g. for selecting appropriate data points for training a machine learning system, testing/verifying/validating a machine learning system.

Various embodiments may receive and use image data (i.e. digital images) such as video, radar, LiDAR, ultrasonic, thermal imaging, motion, sonar etc., for example as a basis for the descriptor images and also audio signals (e.g. simulation results or basis for determining simulation results) and data of other modalities including but not limited to natural language, tabular data, simulated data, technical documents, research papers, AI services, knowledge graphs etc.

The method of Figure 3 may be performed by one or more data processing devices (e.g. computers or microcontrollers) having one or more data processing units. The term "data processing unit" may be understood to mean any type of entity that enables the processing of data or signals. For example, the data or signals may be handled according to at least one (i.e., one or more than one) specific function performed by the data processing unit. A data processing unit may include or be formed from an analogue circuit, a digital circuit, a logic circuit, a microprocessor, a microcontroller, a central processing unit (CPU), a graphics processing unit (GPU), a digital signal processor (DSP), a field programmable gate array (FPGA), or any combination thereof. Any other means for implementing the respective functions described in more detail herein may also be understood to include a data processing unit or logic circuitry. One or more of the method steps described in more detail herein may be performed (e.g., implemented) by a data processing unit through one or more specific functions performed by the data processing unit.

Accordingly, according to one embodiment, the method is computerimplemented.

## Claims

1. A method for configuring a technical system (101), comprising:
providing (301) a large language model (200) with connections (201) to a simulation tool (202) for simulation of the technical system depending on configuration parameters of the technical system and an optimization tool (202) for deriving updated configuration parameters from current values of configuration parameters and a quality value of the current configuration parameters;
inputting (302) one or more prompts (204) into the large language model (200) comprising
information about an application programming interface of the simulation tool (202);
information about an application programming interface of the optimization tool (202);
information about a mapping of simulation result data provided by the simulation tool (202) to the quality value; and
an instruction to determine the configuration parameters to optimize the quality value
configuring (303) the technical system (101) in accordance with values of the configuration parameters determined by the large language model (200) in response to the one or more prompts (204).

2. The method of claim 1, further comprising providing the large language model (200) with a connection (201) to a controller (102) of the technical system (101), wherein the one or more prompts (204) comprise information about an application programming interface of the controller (102) and an instruction to configure the technical system (101) in accordance with values of the configuration parameters determined by the large language model (200) in response to the one or more prompts (204).

3. The method of claim 1 or 2, further comprising providing the large language model (200) with a connection (201) to a mapping tool (202) for mapping the simulation result data provided by the simulation tool (202) to the quality value, wherein the information about the mapping is information about an application programming interface of the mapping tool (202).

4. The method of any one of claims 1 to 3, wherein the one or more prompts (204) comprise examples of inputs and outputs of the application programming interfaces.

5. The method of any one of claims 1 to 4, further comprising providing the large language model (200) with one or more connections (201) to one or more databases containing information about the behaviour of the technical system (101), wherein the one or more prompts (204) include information on how to access the one or more databases and instructions to acquire knowledge from the one or more data bases (203) and take it into account for the determination of the configuration parameters.

6. The method of any one of claims 1 to 5, further comprising providing the large language model (200) with a connection (201) to a machine learning model (200) trained to perform at least a part of the mapping of simulation result data provided by the simulation tool (202) to the quality value and wherein the information about a mapping of simulation result data provided by the simulation tool (202) includes information about an application programming interface of the machine learning model (200).

7. The method of any one of claims 1 to 6, comprising training the large language model (200) with training examples comprising examples for the one or more prompts (204) and target values for the configuration parameters.

8. A data processing device, configured to perform a method of any one of claims 1 to 7.

9. A computer program comprising instructions which, when executed by a computer, makes the computer perform a method according to any one of claims 1 to 7.

10. A computer-readable medium comprising instructions which, when executed by a computer, makes the computer perform a method according to any one of claims 1 to 7.
